# EUROPÄISCHE PATENTSCHRIFT

(11) **EP 3 422 029 B1**
(45) Veröffentlichungstag und Bekanntmachung des Hinweises auf die Patenterteilung: **31.08.2022**
(21) Anmeldenummer: 17178368.1
(22) Anmeldetag: 28.06.2017
(51) Int. Cl.: G01R 31/28

(54) **VORRICHTUNG UND VERFAHREN ZUR FREQUENZCHARAKTERISIERUNG EINES ELEKTRONISCHEN SYSTEMS**
DEVICE AND METHOD FOR SETTING THE FREQUENCY CHARACTERISTICS OF AN ELECTRONIC SYSTEM
DISPOSITIF ET PROCÉDÉ DE CARACTÉRISATION DE FRÉQUENCE D'UN SYSTÈME ÉLECTRONIQUE

(43) Veröffentlichungstag der Anmeldung: 02.01.2019
(73) Patentinhaber: Fraunhofer-Gesellschaft zur Förderung der angewandten Forschung e.V., 80686 München (DE)
(72) Erfinder: Ott, Lepold, 91058 Erlangen (DE); Bodensteiner, Fabian, 91052 Erlangen (DE); Wunder, Bernd, 91058 Erlangen (DE)
(74) Vertreter: 2SPL Patentanwälte PartG mbB

(56) Entgegenhaltungen:
- EP-A1- 1 533 624
- DE-A1-102008 060 385
- US-A1- 2017 003 355
- US-B2- 7 675 293
- BUTTON R M ET AL: "STABILITY TESTING AND ANALYSIS OF A PMAD DC TEST BED FOR THE SPACE STATION FREEDOM", AEROSPACE POWER. SAN DIEGO, AUG 3 - 7, 1992; [PROCEEDINGS OF THE INTERSOCIETY ENERGY CONVERSION ENGINEERING CONFERENCE (IECEC)], NEW YORK, IEEE, US, Bd. 6, 3. August 1992 (1992-08-03), Seiten 6.93-6.98, XP000378479, ISBN: 978-0-7803-0693-6

## Beschreibung

### Technisches Gebiet

Ausführungsbeispiele befassen sich mit der Frequenzcharakterisierung elektronischer Systeme. Insbesondere befassen Ausführungsbeispiele sich mit einer Vorrichtung sowie einem Verfahren zur Frequenzcharakterisierung eines elektronischen Systems.

### Hintergrund

Zur Charakterisierung aktiver und passiver Elektroniksysteme werden häufig Zirp-Signale (sinusförmige Signale mit wechselnder Frequenz) verwendet, die je nach Anwendung entweder kapazitiv oder induktiv in eine Messanordnung eingekoppelt werden. Die Zirp-Signale werden mit Hilfe eines Signalgenerators erzeugt, der in den meisten Fällen ein Teil eines Netzwerkanalysators ist, der auch für die Auswertung der Messsignale verwendet wird. Solche Systeme werden z.B. in Y. Panov et al.: "Practical Issues of Input/Output Impedance Measurements in Switching Power Supplies and Application of Measured Data to Stability Analysis" in Twentieth Annual IEEE Applied Power Electronics Conference and Exposition, Austin, 2005 als auch in L. Ott et al.: "Modelling and Measuring Complex Impedances of Power Electronic Converters for Stability Assessment of Low-Voltage DC-Grids" in Proceedings IEEE First International Conference on DC Microgrids, Atlanta 2015 vorgeschlagen.

In den vorgenannten Verfahren muss die Bandbreite des Messempfängers zur Aufzeichnung der Messungen jedoch deutlich niedriger gewählt werden als die aktuelle Frequenz des Zirp-Signals, so dass die Aufzeichnungsdauer gerade für niedrige Frequenzbereiche sehr lange ist (z.B. im Bereich mehrerer Minuten). Die kapazitive bzw. induktive Einkopplung der Zirp-Signale beschränkt die vorgenannten Verfahren zudem auf gleichspannungsbasierte Anwendungen. Bei einer induktiven Einkopplung des Messsignals muss zudem der Messkreis aufgetrennt werden, um ein induktives Einkoppelglied in die Messanordnung einzubringen. Bei kapazitiver Einkopplung ist aufgrund des notwendigen Einkoppelkondensators keine sichere galvanische Trennung von Messequipment und Messanordnung möglich, so dass zusätzliche induktive Übertragungsglieder zu Isolationszwecken notwendig sind. Somit entsteht ein hoher Aufwand hinsichtlich der benötigten Hardware. Für beide Einkopplungsarten ist zudem die Dimensionierung der passiven Schaltungskomponenten zur Einkopplung hinsichtlich der gewünschten Bandbreite an den spezifischen Anwendungsfall anzupassen, so dass diese Verfahren nicht universell einsetzbar sind. Bei der Vermessung von Anordnungen höherer Leistungsniveaus reichen die zur Verfügung stehenden Signalpegel der Netzwerkanalysatoren zudem nicht mehr aus, um einen ausreichenden Störabstand zu gewährleisten. Es werden daher externe Leistungsverstärker benötigt, was den Aufwand hinsichtlich der benötigten Hardware als auch die Kosten erhöht.

Komplexe Impedanzen leistungselektronischer System können auch unter Verwendung eines einzelnen leistungselektronischen Wandlers, der ein wechselfrequentes Anregungssignal in das zu untersuchen Verteilernetz injiziert und die Antwort des Systems aufzeichnet, vermessen werden. Das wechselfrequente Signal wird dabei entweder dem Strom- oder Spannungssollwert oder direkt dem Tastgradsignal des eingesetzten Wandlers überlagert. Solche Systeme werden z.B. in R. Button et al.: "Stability Testing and Analysis of a PMAD DC Test Bed for the Space Station Freedom" NASA Technical Memorandum 105846, Cleveland, 1992 oder auch in A. Riccobono: "Stabilizing Controller Design for a DC Power Distribution System Using a Passivity-Based Stability Criterion", Columbia: College of Engineering and Computing, University of South Carolina, 2013 vorgeschlagen.

Bei den genannten Verfahren muss eine zusätzliche leistungselektronische Komponente in den Messkreis eingebracht werden, so dass der Arbeitspunkt und damit auch das Frequenzverhalten des gesamten Messkreises verzerrt sein kann. Der auflösbare Frequenzbereich wird durch die Schaltfrequenz bzw. die Eckfrequenz des Ausgangsfilters des Injektionswandlers eingeschränkt. Eine Erweiterung des auflösbaren Frequenzbereichs geht daher mit einem hohen Entwicklungsaufwand einher. Da eine zusätzlich leistungselektronische Komponente benötigt wird, sind auch die Kosten des Verfahrens hoch.

Ferner wird in Druckschrift US 2017/0003355 A1 ein Verfahren und eine Vorrichtung zur Impedanzbestimmung einer Batterie vorgeschlagen. Eine Einstellung des Signalpegels des an die Batterie angelegten Testsignals ist dabei nicht möglich.

Weiterhin werden in den Druckschriften DE 10 2008 060 385 A1, US 7 675 293 B2 und EP 1 533 624 A1 verschieden Verfahren vorgeschlagen, um einen Frequenzgang eines gemessenen Kenngröße zu bestimmen. Jedoch offenbaren die vorgenannten Druckschriften keine variablen Lösungen zum Einkoppeln eines Testsignals in ein zu vermessendes elektronisches System.

Es besteht somit ein Bedürfnis, eine Möglichkeit zur Frequenzcharakterisierung elektronischer Systeme bereitzustellen, die zumindest die vorgenannten Probleme vermeidet.

### Zusammenfassung

Ausführungsbeispiele einer Vorrichtung zur Frequenzcharakterisierung eines elektronischen Systems ermöglichen dies. Die Vorrichtung umfasst zwei Anschlüsse, die eingerichtet sind, mit dem elektronischen System zu koppeln. Ferner umfasst die Vorrichtung eine Steuerschaltung, die eingerichtet ist, ein Testsignal zu erzeugen. Das Testsignal ist ein Rechtecksignal, wobei eine Länge eines Rechteckfensters des Rechtecksignals abhängig von einem gewünschten messbaren Frequenzbereich eingestellt ist. Die Vorrichtung umfasst zudem eine Einkoppelschaltung umfassend eine einstellbare Impedanz und einen Schalter, die in Reihe gekoppelt sind. Endknoten der Einkoppelschaltung sind mit den zwei Anschlüssen gekoppelt. Der Schalter ist dabei eingerichtet, die zwei Anschlüsse basierend auf dem Testsignal elektrisch miteinander zu koppeln. Weiterhin umfasst die Vorrichtung eine Messschaltung, die eingerichtet ist ein erstes Messsignal, das den Strom durch die Einkoppelschaltung repräsentiert, und ein zweites Messsignal, das die Spannung über die Einkoppelschaltung repräsentiert, zu erzeugen. Die Messschaltung ist ferner eingerichtet, das erste Messsignal und das zweite Messsignal synchron zu dem Testsignal zu erzeugen. Die Steuerschaltung ist ferner eingerichtet, basierend auf einer ersten Kreuzkorrelation des ersten Messsignals und des Testsignals sowie einer anschließenden Fourier-Transformation des Ergebnisses der ersten Kreuzkorrelation ein erstes Signal zu erzeugen, dass einen Frequenzverlauf des Stroms durch die Einkoppelschaltung repräsentiert. Zudem ist die Steuerschaltung eingerichtet, basierend auf einer zweiten Kreuzkorrelation des zweiten Messsignal und des Testsignals sowie einer anschließenden Fourier-Transformation des Ergebnisses der zweiten Kreuzkorrelation ein zweites Signal zu erzeugen, dass einen Frequenzverlauf der Spannung über die Einkoppelschaltung repräsentiert.

Weitere Ausführungsbeispiele betreffen einen Gleichspannungswandler. Der Gleichspannungswandler umfasst eine Spannungswandlerschaltung, die eingerichtet ist, eine Eingangsspannung mit einem ersten Spannungsniveau in eine Ausgangsspannung mit einem verschiedenen zweiten Spannungsniveau zu wandeln. Ferner umfasst der Gleichspannungswandler obige Vorrichtung zur Frequenzcharakterisierung eines elektronischen Systems gemäß. Die zwei Anschlüsse der Vorrichtung sind mit Eingangsanschlüssen des Gleichspannungswandlers, die die Eingangsspannung empfangen, oder Ausgangsanschlüssen des Gleichspannungswandlers, die die Ausgangsspannung abgeben, gekoppelt.

Ausführungsbeispiele betreffen ferner ein Verfahren zur Frequenzcharakterisierung eines elektronischen Systems. Das Verfahren umfasst ein Einkoppeln eines Testsignals in das elektronische System. Weiterhin umfasst das Verfahren ein Messen eines Stroms an dem elektronischen System, um zumindest ein Messergebnis zu erzeugen. Zudem umfasst das Verfahren ein Kreuzkorrelieren des zumindest einen Messergebnisses mit dem Testsignal, um ein erstes Korrelationsergebnis zu erzeugen. Das Verfahren umfasst außerdem ein Fourier-transfomieren des ersten Korrelationsergebnisses, um ein erstes Verlaufssignal zu erzeugen, das einen Frequenzverlauf des Stroms repräsentiert. Zudem umfasst das Verfahren ein Messen einer Spannung an dem elektronischen System, um zumindest ein zweites Messergebnis zu erzeugen. Das Verfahren umfasst ein Kreuzkorrelieren des zumindest einen zweiten Messergebnisses mit dem Testsignal, um ein zweites Korrelationsergebnis zu erzeugen. Ferner umfasst das Verfahren ein Fourier-transfomieren des zweiten Korrelationsergebnisses, um ein zweites Verlaufssignal zu erzeugen, das einen Frequenzverlauf der Spannung repräsentiert. Die vorgenannten Verfahrensschritte werden dabei durch eine Vorrichtung zur Frequenzcharakterisierung gemäß einem der Ansprüche 1 bis 3 durchgeführt.

### Figurenkurzbeschreibung

Ausführungsbeispiele werden nachfolgend bezugnehmend auf die beiliegenden Figuren näher erläutert. Es zeigen:
Fig. 1 zeigt ein Ausführungsbeispiel einer Vorrichtung zur Frequenzcharakterisierung eines elektronischen Systems;
Fig. 2 zeigt ein weiteres Ausführungsbeispiel einer Vorrichtung zur Frequenzcharakterisierung eines elektronischen Systems;
Fig. 3 zeigt die Verwendung einer Vorrichtung zur Frequenzcharakterisierung eines elektronischen Systems in einem Gleichspannungsverteilernetz;
Fig. 4 zeigt die Verwendung einer Vorrichtung zur Frequenzcharakterisierung eines elektronischen Systems zur Vermessung eines Filters;
Fig. 5 zeigt ein Ausführungsbeispiel eines Gleichspannungswandlers; und
Fig. 6 zeigt ein Ablaufdiagramm eines Ausführungsbeispiels eines Verfahrens zur Frequenzcharakterisierung eines elektronischen Systems.

### Beschreibung

Verschiedene Ausführungsbeispiele werden nun ausführlicher unter Bezugnahme auf die beiliegenden Zeichnungen beschrieben, in denen einige Ausführungsbeispiele dargestellt sind. In den Figuren können die Dickenabmessungen von Linien, Schichten und/oder Regionen um der Deutlichkeit Willen übertrieben dargestellt sein.

Bei der nachfolgenden Beschreibung der beigefügten Figuren, die lediglich einige exemplarische Ausführungsbeispiele zeigen, können gleiche Bezugszeichen gleiche oder vergleichbare Komponenten bezeichnen. Ferner können zusammenfassende Bezugszeichen für Komponenten und Objekte verwendet werden, die mehrfach in einem Ausführungsbeispiel oder in einer Zeichnung auftreten, jedoch hinsichtlich eines oder mehrerer Merkmale gemeinsam beschrieben werden. Komponenten oder Objekte, die mit gleichen oder zusammenfassenden Bezugszeichen beschrieben werden, können hinsichtlich einzelner, mehrerer oder aller Merkmale, beispielsweise ihrer Dimensionierungen, gleich, jedoch gegebenenfalls auch unterschiedlich ausgeführt sein, sofern sich aus der Beschreibung nicht etwas anderes explizit oder implizit ergibt.

Obwohl Ausführungsbeispiele auf verschiedene Weise modifiziert und abgeändert werden können, sind Ausführungsbeispiele in den Figuren als Beispiele dargestellt und werden hierin ausführlich beschrieben. Es sei jedoch klargestellt, dass nicht beabsichtigt ist, Ausführungsbeispiele auf die jeweils offenbarten Formen zu beschränken, sondern dass Ausführungsbeispiele vielmehr sämtliche funktionale und/oder strukturelle Modifikationen, Äquivalente und Alternativen, die im Bereich der Erfindung liegen, abdecken sollen. Gleiche Bezugszeichen bezeichnen in der gesamten Figurenbeschreibung gleiche oder ähnliche Elemente.

Man beachte, dass ein Element, das als mit einem anderen Element "verbunden" oder "verkoppelt" bezeichnet wird, mit dem anderen Element direkt verbunden oder verkoppelt sein kann oder dass dazwischenliegende Elemente vorhanden sein können.

Die Terminologie, die hierin verwendet wird, dient nur der Beschreibung bestimmter Ausführungsbeispiele und soll die Ausführungsbeispiele nicht beschränken. Wie hierin verwendet, sollen die Singularformen " einer", " eine", "eines" und "der, die, das" auch die Pluralformen beinhalten, solange der Kontext nicht eindeutig etwas anderes angibt. Ferner sei klargestellt, dass die Ausdrücke wie z.B. "beinhaltet", "beinhaltend", aufweist" und/oder "aufweisend", wie hierin verwendet, das Vorhandensein von genannten Merkmalen, ganzen Zahlen, Schritten, Arbeitsabläufen, Elementen und/oder Komponenten angeben, aber das Vorhandensein oder die Hinzufügung von einem bzw. einer oder mehreren Merkmalen, ganzen Zahlen, Schritten, Arbeitsabläufen, Elementen, Komponenten und/oder Gruppen davon nicht ausschließen.

Solange nichts anderes definiert ist, haben sämtliche hierin verwendeten Begriffe (einschließlich von technischen und wissenschaftlichen Begriffen) die gleiche Bedeutung, die ihnen ein Durchschnittsfachmann auf dem Gebiet, zu dem die Ausführungsbeispiele gehören, beimisst. Ferner sei klargestellt, dass Ausdrücke, z.B. diejenigen, die in allgemein verwendeten Wörterbüchern definiert sind, so zu interpretieren sind, als hätten sie die Bedeutung, die mit ihrer Bedeutung im Kontext der einschlägigen Technik konsistent ist, solange dies hierin nicht ausdrücklich anders definiert ist.

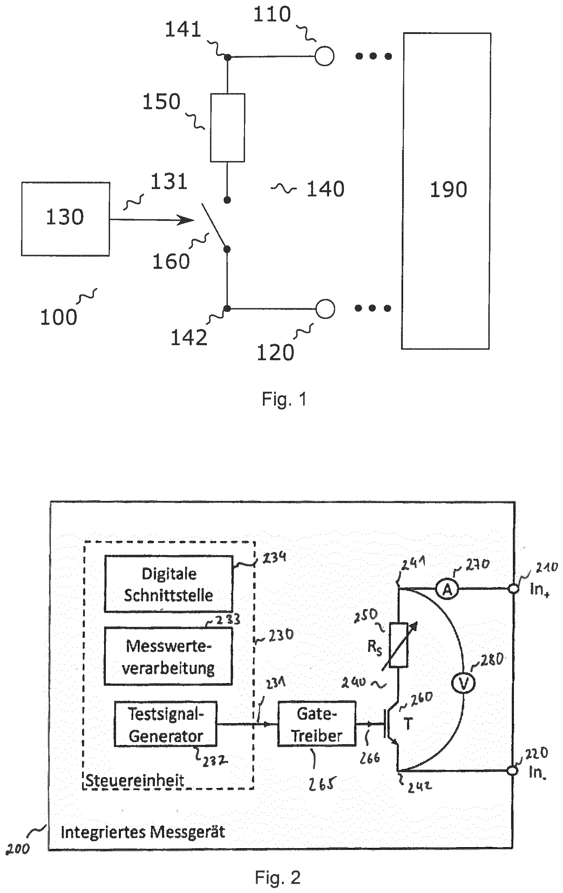

Fig. 1 zeigt eine Vorrichtung 100 zur Frequenzcharakterisierung eines elektronischen Systems 190. Die Vorrichtung 100 umfasst zwei Anschlüsse 110 und 120, die eingerichtet sind, mit dem elektronischen System 190 zu koppeln. Ferner umfasst die Vorrichtung 100 eine Steuerschaltung 130, die eingerichtet ist, ein Testsignal 131 zu erzeugen. Die Vorrichtung 100 umfasst zudem eine Einkoppelschaltung 140 umfassend eine einstellbare Impedanz 150 und einen Schalter 160, die in Reihe gekoppelt sind. Endknoten 141 und 142 der Einkoppelschaltung 140 sind mit den zwei Anschlüssen 110 und 120 gekoppelt. Der Schalter 160 ist dabei eingerichtet, die zwei Anschlüsse 110 und 120 basierend auf dem Testsignal 131 elektrisch miteinander zu koppeln.

Durch die Kopplung der beiden Anschlüssen 110 und 120 gemäß dem Testsignal 131 wird das elektronische System 190 angeregt, d.h. das Testsignal 131 in das elektronische System 190 eingekoppelt. Die Vorrichtung 100 ermöglicht daher eine nicht-invasive Einkopplung des Testsignals 131 in das elektronische System 190 ohne statische Beeinflussung des Arbeitspunktes des elektronischen Systems 190 und somit ohne Verzerrung dessen Frequenzverhaltens. Zudem kann über die einstellbare Impedanz 150 die Amplitude der Anregung, d.h. der Anregungspegel, auf einfache Weise eingestellt werden. Die Vorrichtung 100 kann zur Einkopplung des Testsignals 131 in ein elektronisches System somit an die Charakteristika bzw. Eigenschaften des elektronischen Systems angepasst werden.

Die Anschlüsse 110 und 120 können dabei jede geeignete Art von Anschlüssen bzw. Verbindungselementen sein, um die Vorrichtung 100 mit einem elektronischen System 190 zu koppeln. Beispielsweise kann es sich bei den Anschlüssen 110 und 120 um Stecker, Buchsen, Klemmen, Drähte, Lötstellen etc. handeln.

Bei der Steuerschaltung 130 kann es sich um jegliche elektronische Baugruppe handeln, die das Testsignal 131 kontrolliert erzeugen kann. Bei dem Testsignal 131 kann es sich um jegliches analoge oder digitale Signal handeln, das geeignet ist, das elektronische System 190 anzuregen. Das Testsignal 131 kann z.B. ein Rechtecksignal oder eine pseudozufällige Binärsequenz (engl. Pseudo Random Binary Sequence, PRBS) sein. Die Steuerschaltung 130 kann daher z.B. einen Oszillator (z.B. Quarzoszillator), einen Rechteckgenerator (z.B. astabiler Multivibrator oder Schmitt-Trigger) und/oder einen Zufallsgenerator umfassen. Die Steuerschaltung kann auch Komponenten wie einen Prozessor, einen Computerprozessor (CPU = Central Processing Unit), einen anwendungsspezifischen integrierten Schaltkreis (ASIC = Application-Specific Integrated Circuit), einen integrierten Schaltkreis (IC = Integrated Circuit), ein Ein-Chip-System (SOC = System on Chip), ein programmierbares Logikelement oder ein feldprogrammierbares Gatterarray mit einem Mikroprozessor (FPGA = Field Programmable Gate Array) aufweisen, auf den Software für die Erzeugung bzw. die Steuerung der Erzeugung des Testsignals 131 abläuft.

Die einstellbare Impedanz 150 kann jedes beliebige Bauelement sein, das einen einstellbaren Impedanzwert aufweist (z.B. Potentiometer oder linear betriebener Leistungstransistor). Wie bereits oben angedeutet, kann über die einstellbare Impedanz 150 die Amplitude der in das elektronische System 190 eingebrachten Anregung veränderlich eingestellt werden. Der Impedanzwert der einstellbaren Impedanz 150 kann dabei basierend auf einer Arbeitsspannung und/oder einem Arbeitsstrom des elektronischen Systems 190 bestimmt sein. Beispielsweise kann die Steuerschaltung 130 ferner eingerichtet sein, den Impedanzwert der einstellbaren Impedanz 150 abhängig von der Arbeitsspannung und/oder dem Arbeitsstrom des elektronischen Systems 190 einzustellen. Derart kann die Einkopplung des Testsignals 131 an die Eigenschaften des elektronischen Systems 190 angepasst werden.

Der Schalter 160 ist eine Baugruppe, die mittels zweier elektrisch leitender Materialien oder eines Halbleiterbauelements eine elektrisch leitende Verbindung herstellt oder trennt. Beispielsweise kann der Schalter 160 ein Transistor sein. Die Vorrichtung 100 kann dann ferner einen Treiber umfassen, der eingerichtet ist, die Leitfähigkeit des Transistors basierend auf dem Testsignal 131 zu steuern.

Ferner kann die Vorrichtung auch eine Messschaltung (nicht gezeigt) umfassen. Beispielsweise kann die Messschaltung eingerichtet sein, ein erstes Messsignal, das den Strom durch die Einkoppelschaltung 140 repräsentiert, und/oder ein zweites Messsignal, das die Spannung über die Einkoppelschaltung 140 repräsentiert, zu erzeugen. Mit anderen Worten: Die Vorrichtung 100 kann optional auch Mittel zur Messung der Impulsantworten des elektronischen Systems 190 umfassen. Das erste und das zweite Messsignal können dabei sowohl digitale als auch analoge Signale sein.

Die Messung kann dabei breitbandig erfolgen. Wenn das Testsignal 131 eine PRBS ist, kann die Messbandbreite der Messschaltung z.B. bis zu 50 % einer Abtastfrequenz Testsignals 131 betragen. Entsprechend kann die notwendige Zeitdauer für die Aufzeichnung der Impulsantworten des elektronischen Systems 190 wesentlich verkürzt sein. Insbesondere bei der Verwendung von Rechtecksignalen oder pseudozufälligen Binärsequenzen als Testsignal 131 unterliegt die Messbandbreite im Vergleich zu Zirp-Signalen keiner Bandbreitenbeschränkung. Dies ermöglicht eine zügige Auswertung der Impulsantworten des elektronischen Systems 190.

Die Steuerschaltung 130 ist ferner eingerichtet, basierend auf dem ersten Messsignal und dem Testsignal 131 ein erstes Signal zu erzeugen, dass einen Frequenzverlauf des Stroms durch die Einkoppelschaltung 140 repräsentiert. Ergänzend ist die Steuerschaltung 130 auch eingerichtet, basierend auf dem zweiten Messsignal und dem Testsignal 131 ein zweites Signal zu erzeugen, dass einen Frequenzverlauf der Spannung über die Einkoppelschaltung 140 repräsentiert. Die Frequenzverläufe von Spannung und Strom repräsentieren frequenzabhängige Charakteristika des elektronischen Systems 190. Zudem können aus den Frequenzverläufen von Spannung und Strom weitere frequenzabhängige Charakteristika des elektronischen Systems 190 abgeleitet werden. Um das erste Signal bzw. das zweite Signal zu erzeugen, ist die Steuerschaltung 130 eingerichtet, das erste bzw. das zweite Messsignal mit dem Testsignal 131 zu kreuzkorrelieren.

Um eine möglichst optimale Auflösung im Frequenzbereich zu ermöglichen, ist die Messschaltung ferner eingerichtet, das erste Messsignal und das zweite Messsignal synchron zu dem Testsignal 131 zu erzeugen. Das heißt, die Erfassung der Messwerte für Strom und Spannung erfolgt synchron zu dem Testsignal 131.

Aufbaubedingte Einschränkungen des messbaren Frequenzbereichs durch z.B. die Schaltfrequenz eines Injektionswandlers, Filterstufen oder passive Einkopplungsglieder können durch die Vorrichtung 100 vermieden werden. Wird eine PRBS als Testsignal 131 verwendet, kann der messbare Frequenzbereich z.B. durch die Taktfrequenz des Signals und die Anzahl der verwendeten Bits für die Sequenz festgelegt werden. Da ein Rechtecksignal als Testsignal 131 verwendet wird, wird der messbare Frequenzbereich durch die Länge des Rechteckfensters eingestellt.

Eine Anpassung der Frequenzauflösung an das zu untersuchende elektronische System ist somit in beiden Fällen adaptiv, d.h. ohne Änderung im Hardwareaufbau, möglich.

In **Fig. 2** ist eine weitere Vorrichtung 200 zur Frequenzcharakterisierung elektronischer Systeme gemäß der vorgeschlagenen Architektur gezeigt.

Die Vorrichtung 200 weißt wiederum zwei Anschlüsse 210 und 220 auf, um die Vorrichtung 200 mit einem elektronischen System (nicht gezeigt) zu koppeln.

Eine Steuerschaltung 230 der Vorrichtung 200 umfasst einen Testsignalgenerator 232, um ein Testsignal 231 zu erzeugen. Je nach gewünschter Anregungsamplitude kann das Testsignal 231 z.B. eine oder mehrere Perioden eines PRBS- oder Rechtecksignals zur breitbandigen Anregung von Frequenzanteilen umfassen.

Die Einkopplung des Testsignals 231 in das zu untersuchende elektronische System erfolgt über eine Einkoppelschaltung 240. Die Einkoppelschaltung 240 umfasst eine einstellbare Impedanz 250 (d.h. einen Begrenzungswiderstand) und einen Schalter in Form eines Transistors 260, d.h. einen Halbleiterschalter (mit entsprechender Spannungsfestigkeit und Stromtragfähigkeit). Die Impedanz 250 und der Transistor 260 sind in Reihe gekoppelt. Endknoten 241 und 242 der Einkoppelschaltung 240 sind mit den zwei Anschlüssen 210 und 220 gekoppelt. Über den Transistor 260 werden die zwei Anschlüsse 210 und 220 basierend auf dem Testsignal 230 elektrisch miteinander gekoppelt. Dazu umfasst die Vorrichtung 200 ferner einen Treiber 265, der das Testsignal 231 empfängt und basierend darauf ein Steuersignal 266 an den Gate-Anschluss des Transistors 260 anlegt, um so die Leitfähigkeit des Transistors 260 basierend auf dem Testsignal 231 zu steuern

Das Testsignal 231 wird in der Steuerschaltung 230 digital oder analog erzeugt und gibt die Länge der Einschalt- bzw. Ausschaltzeiten des Transistors 260 während einer Messperiode vor. Beispielsweise kann das Testsignal 231 dem Treiber 265 als logisches Eingangssignal übergeben werden.

Wie bereits oben angedeutet, kann über die einstellbare Impedanz 250 die Anregungsamplitude veränderlich eingestellt werden. Beispielsweise kann die einstellbare Impedanz 250 ein Potentiometer oder ein linear betreibbarer Leistungstransistor sein. Die Einstellung der Impedanz 250 kann z.B. in Abhängigkeit der Arbeitspunktgrößen für Spannung und Strom der zu untersuchenden Anordnung erfolgen.

Aufbaubedingte Einschränkungen des messbaren Frequenzbereichs durch z.B. die Schaltfrequenz eines Injektionswandlers, Filterstufen oder passive Einkopplungsglieder können durch die Vorrichtung 200 vermieden werden. Wie bereits oben ausgeführt, kann der messbare Frequenzbereich für ein PRBS-Testsignal z.B. durch die Taktfrequenz des Signals und die Anzahl der verwendeten Bits für die Sequenz festgelegt werden. Bei dem Rechteck-Testsignal wird der messbare Frequenzbereich durch die Länge des Rechteckfensters eingestellt. Eine Anpassung der Frequenzauflösung an das zu untersuchende elektronische System ist somit in beiden Fällen adaptiv, d.h. ohne Änderung im Hardwareaufbau, möglich.

Die Einkopplung des Testsignals 231 in die zu vermessende Anordnung erfolgt somit grundlegend verschieden im Vergleich zu gewöhnlichen induktiven oder kapazitiven Einkoppelschaltungen oder auch separaten leistungselektronischen Wandlern.

Die Vorrichtung 200 ermöglicht deshalb eine nicht-invasive Einkopplung des Testsignals 231 in ein elektronisches System ohne statische Beeinflussung des Arbeitspunktes des elektronischen Systems und somit ohne Verzerrung dessen Frequenzverhaltens. Zudem kann über die einstellbare Impedanz 250 der Testsignalpegel auf einfache Weise eingestellt werden. Das Testsignal 231 kann somit mit geringem Hardwareaufwand und damit geringen Kosten in ein elektronisches System eingekoppelt werden.

Die Vorrichtung 200 umfasst zudem eine Messschaltung mit einem ersten Messkanal 270, der eingerichtet ist, ein erstes Messsignal, das den Strom durch die Einkoppelschaltung 240 repräsentiert, zu erzeugen und einem zweiten Messkanal 280, der eingerichtet ist, ein zweites Messsignal, das die Spannung über die Einkoppelschaltung 240 repräsentiert, zu erzeugen. Die beiden Messkanäle 270 und 280 können dabei breitbandig ausgeführt sein. Beispielsweise kann die Messbandbreite der Messkanäle 270 und 280 bis zu 50 % einer Abtastfrequenz des Testsignals 231 betragen, wenn das Testsignal 231 ein PRBS-Signal ist. Die Erfassung der Messwerte erfolgt synchronisiert mit der Einkopplung des Testsignals 231 in den Messkreis (d.h. das elektronische System), um eine verbesserte Auflösung im Frequenzbereich zu erreichen.

Die Steuerschaltung 230 verarbeitet nunmehr auch die beiden Messsignale, d.h. das Strom- und das Spannungssignal. Die beiden Messsignale werden mit dem Testsignal 231 durch eine Messwerteverarbeitungsschaltung 233 der Steuerschaltung 230 kreuzkorreliert und anschließend mittels (diskreter) Fourier-Transformation in den Frequenzbereich transformiert.

Aus den so erhaltenen Frequenzverläufen für Strom und Spannung können die gesuchten Frequenzeigenschaften des untersuchten elektronischen Systems erhalten werden. Beispielsweise kann derart eine komplexe Impedanz des untersuchten elektronischen Systems bestimmt werden.

Optional können die beiden Messsignale als auch die Signale, welche den Strom- bzw. Spannungsverlauf über die Frequenz repräsentieren, über eine Schnittstelle 234 an externe Geräte (z.B. Computer, Laptop, Funksender etc.) übertragen werden. Bei der Schnittstelle 234 kann es sich sowohl um eine kabelgebundene als auch um eine drahtlose Schnittstelle handeln. Ebenso kann es sich bei der Schnittstelle 234 um eine digitale Schnittstelle, wie in Fig. 2 angedeutet, oder um eine analoge Schnittstelle handeln. Über die Schnittstelle können z.B. auch Detaileinstellungen für das Testsignal 231 (z.B. Anzahl der verwendeten Bits für PRBS-Signal, Länge der Rechteckimpulse oder Anzahl der einzukoppelnden Messperioden) oder die Abtastfrequenz der Messkanäle 270 und 280 eingestellt werden. Alternativ kann die Vorrichtung 200 auch entsprechende Eingabemittel (z.B. Tasten, berührungsempfindlicher Bildschirm) umfassen, so dass ein Benutzer entsprechende Eingaben auch an der Vorrichtung 200 selbst vornehmen kann.

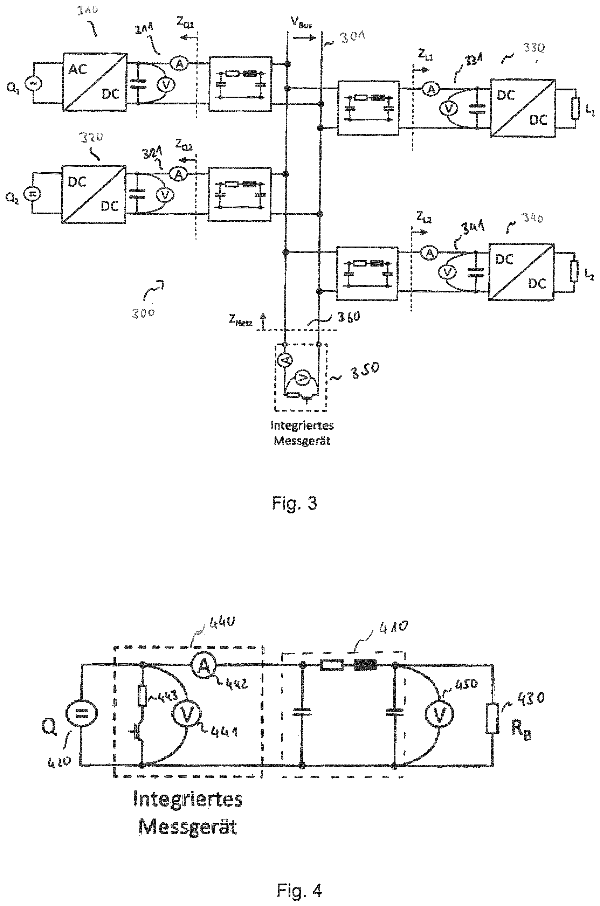

Mit der Vorrichtung 200 können eine Vielzahl von Mess- und Prüfaufgaben an aktiven als auch passiven elektronischen Komponenten (Systemen) durchgeführt werden. Nachfolgend sind in Zusammenhang mit den Figs. 3 bis 5 einige beispielhafte Verwendungen von Vorrichtung zur Frequenzcharakterisierung elektronischer Systeme gemäß der vorgeschlagenen Architektur bzw. einem gemäß einem oder mehreren der vorangehend beschriebenen Ausführungsbeispiele gezeigt.

**Fig. 3** zeigt ein vier Teilnehmer 310, 320, 330 und 340 umfassenden Gleichspannungsnetz 300. Die vier Teilnehmer 310, 320, 330 und 340 sind an einer zentralen Sammelschiene 301 des sternförmigen Gleichspannungsnetzes 300 angebracht.

Eine Vorrichtung 350 zur Frequenzcharakterisierung elektronischer Systeme gemäß der vorgeschlagenen Architektur bzw. einem gemäß einem oder mehreren der vorangehend beschriebenen Ausführungsbeispiele kann an einer beliebigen Stelle an das Gleichspannungsnetz 300 angebunden werden. Wie in Fig. 3 gezeigt, kann die Vorrichtung 350 z.B. an die zentrale Sammelschiene 301 gekoppelt werden.

Je nach Positionierung der Messstellen für Strom und Spannung innerhalb des Gleichspannungsnetzes 300 können mit dem gezeigten Aufbau nun z.B. verschiedene komplexe Impedanzverläufe bestimmt werden. Werden die internen Messkanäle der Vorrichtung 300 verwendet, d.h. die Vorrichtung 300 dient auch als Messgerät, so ist die Bestimmung der gesamten resultierenden Netzimpedanz Z_{Netz} am Anschlusspunkt 360 der Vorrichtung 350 möglich. Die Netzimpedanz Z_{Netz} ergibt sich aus den Impedanzen aller angeschlossenen Teilnehmer 310, 320, 330 und 340 im Zusammenschluss mit den Kabelimpedanzen.

Die Vorrichtung 350 ist dazu eingerichtet, nach den oben in Zusammenhang mit Fig. 1 und Fig. 2 dargestellten Grundsätzen die gemessenen Signale für Strom und Spannung mit dem eingekoppelten Testsignal kreuzkorrelieren und Fourier-transformieren, um die frequenzabhängigen Verläufe für Strom und Spannung zu ermitteln.

Wie in Fig. 3 dargestellt, können mittels externer Messstellen (Messschaltungen) 311, 321, 331, 341 für Strom und/oder Spannung auch die komplexen Impedanzen der einzelnen angeschlossenen Teilnehmer 310, 320, 330 bzw. 340 unter beliebigen Arbeitspunkten gemäß den obigen Grundsätzen gemessen bzw. ermittelt werden. Beispielsweise kann der komplexe Impedanzverlauf Z_{Q1} des Teilnehmers 310 (welcher eine Quelle darstellt) mittels der externen Messstelle 311, die direkt mit den Anschlüssen des Teilnehmers 310 gekoppelt ist, gemäß den obigen Grundsätzen gemessen bzw. ermittelt werden. So können z.B. der an den Anschlüssen des Teilnehmers 310 gemessene Strom bzw. die Spannung mit dem durch die Vorrichtung 350 eingekoppelten Testsignal kreuzkorreliert und anschließen Fouriertransformiert werden. Aus den so bestimmten Frequenzverläufen von Strom und Spannung kann nur der Impedanzverlauf Z_{Q1} bestimmt werden.

Wie in Fig. 3 angedeutet, umfasst die Vorrichtung 350 auch eine Messschaltung für die Messung des Stroms durch die Einkoppelschaltung der Vorrichtung 350 und der Spannung über der Einkoppelschaltung der Vorrichtung 350.

Die kurze Mess- bzw. Auswertedauer der vorgeschlagenen Architektur (z.B. einige Sekunden) kann auch die Überprüfung der Eigenschaften von elektronischen Baugruppen bzw. Funktionstests ermöglichen. Beispielsweise können derart in automatisierten Massenfertigungsanlagen für elektronischen Baugruppen die elektronischen Baugruppen geprüft werden. Dies ist in **Fig. 4** beispielhaft für eine π-Filterstruktur 410 gezeigt.

Ähnlich wie im obigen Beispiel der Vermessung komplexer Impedanzen in einem Verteilernetz, ist auch bei dem in Fig. 4 gezeigten Beispiel die Bestimmung verschiedener Eigenschaften der untersuchten Elektronikkomponente (hier die π-Filterstruktur 410) möglich.

Bei dem in Fig. 4 gezeigten Beispiel werden eine Spannungsquelle 420 und ein Widerstand 430 mit der π-Filterstruktur 410 gekoppelt, um diese mit einem festen Arbeitspunkt zu belasten. Zudem wird eine Vorrichtung 440 zur Frequenzcharakterisierung elektronischer Systeme gemäß der vorgeschlagenen Architektur bzw. einem gemäß einem oder mehreren der vorangehend beschriebenen Ausführungsbeispiele mit der π-Filterstruktur 410 gekoppelt. Die Messschaltung der Vorrichtung 440 mit ihren Messkanälen 441 und 442 für Strom bzw. Spannung an bzw. über der Einkoppelschaltung 443 kann die Eingangsimpedanz der π-Filterstruktur 410 gemäß den oben beschriebenen Grundsätzen bestimmt werden. Wird anstelle des internen Strommesskanals 442 am Ausgang der π-Filterstruktur 410 z.B. eine zweite, externe Messschaltung 450 zur Spannungsmessung verwendet, so kann die Übertragungsfunktion der π-Filterstruktur 410 gemessen werden. Die Messung der Messschaltung 450 kann dabei wiederum synchron zu dem durch die Vorrichtung 440 eingekoppelten Testsignal erfolgen.

Die Verwendung von Vorrichtungen zur Frequenzcharakterisierung elektronischer Systeme gemäß der vorgeschlagenen Architektur bzw. einem gemäß einem oder mehreren der vorangehend beschriebenen Ausführungsbeispiele ist dabei jedoch nicht auf die Vermessung von komplexen Frequenzeigenschaften von leistungselektronischen Systemen beschränkt. So können z.B. auch die komplexen Impedanzverläufe von Photovoltaikstrings oder Batteriepacks mit einem Messaufbau, wie er in Fig. 4 gezeigt ist, gemessen werden. Gerade bei Anwendungen mit einer hohen Sensitivität gegenüber dem aktuellen Arbeitspunkt kann die Messung gemäß der vorgeschlagenen Architektur durch seine kurze Messdauer erhebliche Vorteile gegenüber konventionellen Ansätzen aufweisen. Durch die Verwendungen von Zirp-Signalen zur Frequenzcharakterisierung in den konventionellen Ansätzen kann ein Verweilen der zu messenden Anordnung in einem konstanten Arbeitspunkt nicht immer sichergestellt werden.

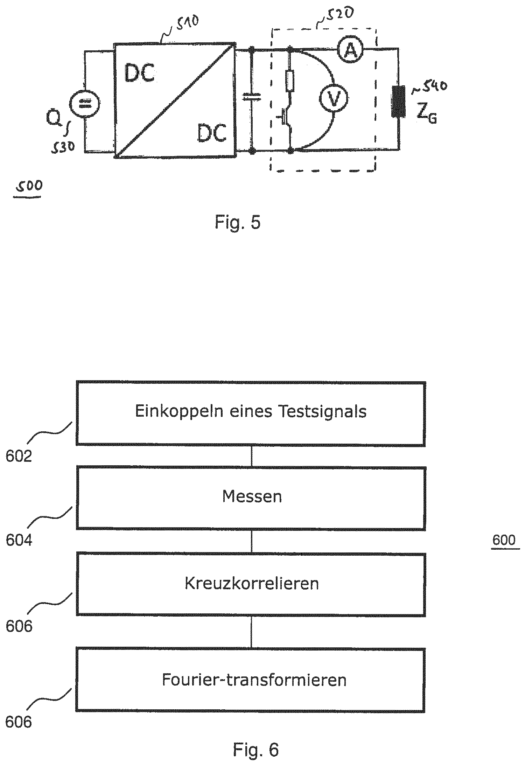

Eine weitere Verwendung von Vorrichtungen zur Frequenzcharakterisierung elektronischer Systeme gemäß der vorgeschlagenen Architektur bzw. einem gemäß einem oder mehreren der vorangehend beschriebenen Ausführungsbeispiele ist in **Fig. 5** gezeigt. Fig. 5 zeigt einen Gleichspannungswandler 500.

Der Gleichspannungswandler 500 umfasst eine Spannungswandlerschaltung 510, die eingerichtet ist, eine Eingangsspannung mit einem ersten Spannungsniveau (z.B. 1 V, 2 V oder 6 V) in eine Ausgangsspannung mit einem verschiedenen zweiten Spannungsniveau (z.B. 12 V, 24 V oder 48 V) zu wandeln. Ferner umfasst der Gleichspannungswandler 500 eine Vorrichtung 520 zur Frequenzcharakterisierung eines elektronischen Systems gemäß der vorgeschlagenen Architektur bzw. einem gemäß einem oder mehreren der vorangehend beschriebenen Ausführungsbeispiele. Die zwei Anschlüsse der Vorrichtung 520 können sowohl mit Eingangsanschlüssen des Gleichspannungswandlers 500, die die Eingangsspannung empfangen, oder wie in Fig. 5 gezeigt mit Ausgangsanschlüssen des Gleichspannungswandlers 500, die die Ausgangsspannung abgeben, gekoppelt sein.

Entsprechend können z.B. die komplexe Impedanz der Spannungsquelle 530, die den Gleichspannungswandler 500 mit der Eingangsspannung versorgt, oder der Last 540, an welche der Gleichspannungswandler 500 die Ausgangsspannung abgibt, bestimmt werden. Bei dem in Fig. 5 gezeigten Beispiel ist die Last 540 ein angeschlossenes Gleichspannungsnetz, so dass die komplexe Impedanz Z_{G} des Gleichspannungsnetzes bestimmt werden kann.

Die aufgezeichneten Messwerte können innerhalb des Gleichspannungswandlers 500 z.B. für die Anpassung von Regelparametern oder für Sicherheitsfunktionen durch die Erkennung von Fehlerfällen im Gleichspannungsnetz verwendet werden.

Entsprechend kann die Vorrichtung 520 eingerichtet sein, ein Impedanzsignal auszugeben, das eine Impedanz an den Eingangsanschlüssen oder den Ausgangsanschlüssen des Gleichspannungswandlers 500 repräsentiert. Die Spannungswandlerschaltung 510 kann dann eingerichtet sein, einen Regelparameter basierend auf dem Impedanzsignal einzustellen und/oder eine Sicherheitsroutine basierend auf dem Impedanzsignal auszuführen.

Die Grundzüge der Frequenzcharakterisierung eines elektronischen Systems gemäß den oben beschriebenen Ausführungsbeispielen sind nochmals in **Fig. 6** zusammengefasst, welche ein Ablaufdiagramm eines Verfahrens 600 zur Frequenzcharakterisierung eines elektronischen Systems zeigt.

Das Verfahren 600 umfasst ein Einkoppeln 602 eines Testsignals in das elektronische System unter Verwendung einer Vorrichtung zur Frequenzcharakterisierung gemäß der vorgeschlagenen Architektur bzw. einem gemäß einem oder mehreren der vorangehend beschriebenen Ausführungsbeispiele. Weiterhin umfasst das Verfahren 600 ein Messen 604 eines ersten Stroms und einer ersten Spannung an dem elektronischen System, um zumindest ein Messergebnis zu erzeugen. Zudem umfasst das Verfahren 600 ein Kreuzkorrelieren 606 des zumindest einen Messergebnisses mit dem Testsignal, um ein erstes Korrelationsergebnis zu erzeugen. Das Verfahren 600 umfasst außerdem ein Fourier-transfomieren 608 des ersten Korrelationsergebnisses, um ein erstes Verlaufssignal zu erzeugen, das einen Frequenzverlauf des Stroms und der Spannung repräsentiert.

Die Verwendung einer Vorrichtung zur Frequenzcharakterisierung gemäß der vorgeschlagenen Architektur bzw. einem gemäß einem oder mehreren der vorangehend beschriebenen Ausführungsbeispiele ermöglicht eine nicht-invasive Einkopplung des Testsignals in das elektronische System ohne statische Beeinflussung des Arbeitspunktes des elektronischen Systems und somit ohne Verzerrung dessen Frequenzverhaltens. Aufbaubedingte Einschränkungen des messbaren Frequenzbereichs hinsichtlich des ersten Stroms und/oder der ersten Spannung können durch die Vorrichtung 100 ebenso vermieden werden. Entsprechend wird eine zügige Auswertung der Impulsantworten des elektronischen Systems ermöglicht.

Wie oben beschrieben, kann das Verfahren 600 ferner ein Messen eines zweiten Stroms und/oder einer zweiten Spannung an dem elektronischen System umfassen, um zumindest ein zweites Messergebnis zu erzeugen. Ebenso kann das Verfahren 600 weiterhin ein Kreuzkorrelieren des zumindest einen zweiten Messergebnisses mit dem Testsignal umfassen, um ein zweites Korrelationsergebnis zu erzeugen. Auch kann das Verfahren 600 ein Fourier-transfomieren des zweiten Korrelationsergebnisses umfassen, um ein zweites Verlaufssignal zu erzeugen, das einen Frequenzverlauf des zweiten Stroms und/oder der zweiten Spannung repräsentiert.

Der erste Strom und die erste Spannung werden dabei unter Verwendung einer der obigen Vorrichtungen zur Frequenzcharakterisierung gemessen, wie vorgehend beschrieben.

Beispielsweise können der erste Strom und/oder die erste Spannung mit einer Messbandbreite bis zu 50 % einer Abtastfrequenz des Testsignals gemessen werden, wenn das Testsignal eine PRBS ist.

Weitere Details und Aspekte des Verfahrens 600 sind vorangehend in Zusammenhang mit einem oder mehreren Ausführungsbeispielen (z.B. Figs. 1 und 2) beschrieben. Das Verfahren 600 kann eines oder mehrere optionale Merkmale gemäß einem oder mehreren der vorangehend beschriebenen Ausführungsbeispiele umfassen.

Wie bereits oben ausgeführt, kann das Verfahren 600 eine kurze Dauer von Messperioden (z.B. im Bereich von mehreren 100 ms) ermöglichen, was insbesondere im Hinblick auf die Bestimmung von Frequenzcharakteristiken von Systemen mit hoher Sensitivität gegenüber dem aktuellen Arbeitspunkt (z.B. Batteriesystem oder Photovoltaikanlage) vorteilhaft ist. Auch die Möglichkeit der raschen Auswertung der Messergebnisse (z.B. innerhalb weniger Sekunden) bietet in der ingenieurswissenschaftlichen Entwicklungspraxis als auch in der automatisierten Fertigung von Elektroniksystem große Vorteile.

Während bei konventionellen Verfahren zur Bestimmung von Frequenzeigenschaften eines Systems mit Hilfe von Zirp-Signalen die passiven Einkoppelsysteme zur Anpassung der Anregungsamplitude an die zu untersuchende Anordnung aufwendig angepasst werden müssen, kann gemäß der vorgeschlagenen Architektur eine Anpassung der Anregungsamplitude augenblicklich über die einstellbare Impedanz der Einkoppelschaltung erfolgen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Vorrichtung (100) zur Frequenzcharakterisierung eines elektronischen Systems (190), umfassend:
zwei Anschlüsse (110, 120), die eingerichtet sind, mit dem elektronischen System (190) zu koppeln;
eine Steuerschaltung (130), die eingerichtet ist, ein Testsignal (131) zu erzeugen, wobei das Testsignal (131) ein Rechtecksignal ist, und wobei eine Länge eines Rechteckfensters des Rechtecksignals abhängig von einem gewünschten messbaren Frequenzbereich eingestellt ist;
eine Einkoppelschaltung (140) umfassend eine einstellbare Impedanz (150) und einen Schalter (160), die in Reihe gekoppelt sind, wobei Endknoten (141, 142) der Einkoppelschaltung (140) mit den zwei Anschlüssen (110, 120) gekoppelt sind, und wobei der Schalter (160) eingerichtet ist, die zwei Anschlüsse (110, 120) basierend auf dem Testsignal (130) elektrisch miteinander zu koppeln; und
eine Messschaltung (270, 280), die eingerichtet ist ein erstes Messsignal, das den Strom durch die Einkoppelschaltung (140) repräsentiert, und ein zweites Messsignal, das die Spannung über die Einkoppelschaltung (140) repräsentiert, zu erzeugen, wobei die Messschaltung (270, 280) ferner eingerichtet ist, das erste Messsignal und das zweite Messsignal synchron zu dem Testsignal (131) zu erzeugen,
wobei die Steuerschaltung (130) ferner eingerichtet ist:
basierend auf einer ersten Kreuzkorrelation des ersten Messsignals und des Testsignals (131) sowie einer anschließenden Fourier-Transformation des Ergebnisses der ersten Kreuzkorrelation ein erstes Signal zu erzeugen, dass einen Frequenzverlauf des Stroms durch die Einkoppelschaltung (140) repräsentiert; und
basierend auf einer zweiten Kreuzkorrelation des zweiten Messsignal und des Testsignals (130) sowie einer anschließenden Fourier-Transformation des Ergebnisses der zweiten Kreuzkorrelation ein zweites Signal zu erzeugen, dass einen Frequenzverlauf der Spannung über die Einkoppelschaltung (140) repräsentiert.

2. Vorrichtung nach Anspruch 1, wobei die Steuerschaltung (130) ferner eingerichtet ist, einen Impedanzwert der einstellbaren Impedanz (150) abhängig von einer Arbeitsspannung und/oder einem Arbeitsstrom des elektronischen Systems (190) einzustellen.

3. Vorrichtung nach Anspruch 1 oder Anspruch 2, wobei der Schalter (160) ein Transistor (260) ist, und wobei die Vorrichtung ferner einen Treiber (265) umfasst, der eingerichtet ist, die Leitfähigkeit des Transistors (260) basierend auf dem Testsignal (131) zu steuern.

4. Gleichspannungswandler (500), umfassend:
eine Spannungswandlerschaltung (510), die eingerichtet ist, eine Eingangsspannung mit einem ersten Spannungsniveau in eine Ausgangsspannung mit einem verschiedenen zweiten Spannungsniveau zu wandeln; und
eine Vorrichtung (520) zur Frequenzcharakterisierung eines elektronischen Systems gemäß einem der Ansprüche 1 bis 3, wobei die zwei Anschlüsse der Vorrichtung mit Eingangsanschlüssen des Gleichspannungswandlers, die die Eingangsspannung empfangen, oder Ausgangsanschlüssen des Gleichspannungswandlers, die die Ausgangsspannung abgeben, gekoppelt sind.

5. Gleichspannungswandler nach Anspruch 4, wobei die Vorrichtung (520) zur Frequenzcharakterisierung ferner eingerichtet ist, ein Impedanzsignal auszugeben, das eine Impedanz an den Eingangsanschlüssen oder den Ausgangsanschlüssen des Gleichspannungswandlers repräsentiert, und wobei die Spannungswandlerschaltung (510) eingerichtet ist:
einen Regelparameter basierend auf dem Impedanzsignal einzustellen; und/oder
eine Sicherheitsroutine basierend auf dem Impedanzsignal auszuführen.

6. Verfahren (600) zur Frequenzcharakterisierung eines elektronischen Systems, umfassend:
Einkoppeln (602) eines Testsignals in das elektronische System;
Messen (604) eines Stroms an dem elektronischen System, um zumindest ein Messergebnis zu erzeugen;
Kreuzkorrelieren (606) des zumindest einen Messergebnisses mit dem Testsignal, um ein erstes Korrelationsergebnis zu erzeugen;
Fourier-transfomieren (608) des ersten Korrelationsergebnisses, um ein erstes Verlaufssignal zu erzeugen, das einen Frequenzverlauf des Stroms repräsentiert;
Messen einer Spannung an dem elektronischen System, um zumindest ein zweites Messergebnis zu erzeugen;
Kreuzkorrelieren des zumindest einen zweiten Messergebnisses mit dem Testsignal, um ein zweites Korrelationsergebnis zu erzeugen; und
Fourier-transfomieren des zweiten Korrelationsergebnisses, um ein zweites Verlaufssignal zu erzeugen, das einen Frequenzverlauf der Spannung repräsentiert,
wobei die vorgenannten Verfahrensschritte durch eine Vorrichtung zur Frequenzcharakterisierung gemäß einem der Ansprüche 1 bis 3 durchgeführt werden.

## Claims

1. An apparatus (100) for frequency characterization of an electronic system (190), comprising:
two terminals (110, 120) configured to couple to the electronic system (190);
a control circuit (130) configured to generate a test signal (131), wherein the test signal (131) is a square-wave signal, and wherein a length of a square-wave window of the square-wave signal is set depending on a desired measurable frequency range;
a coupling circuit (140) comprising an adjustable impedance (150) and a switch (160) which are coupled in series, wherein end nodes (141, 142) of the coupling circuit (140) are coupled to the two terminals (110, 120), and wherein the switch (160) is configured to electrically couple the two terminals (110, 120) based on the test signal (130); and
a measurement circuit (270, 280) configured to generate a first measurement signal representing the current through the coupling circuit (140), and a second measurement signal representing the voltage across the coupling circuit (140), wherein the measurement circuit (270, 280) is further configured to generate the first measurement signal and the second measurement signal synchronously with the test signal (131),
wherein the control circuit (130) is further configured to:
based on a first cross-correlation of the first measurement signal and the test signal (131) as well as a subsequent Fourier transformation of the result of the first cross-correlation, generate a first signal representing a frequency course of the current through the coupling circuit (140); and
based on a second cross-correlation of the second measurement signal and the test signal (130) as well as a subsequent Fourier transformation of the result of the second cross-correlation, generate a second signal representing a frequency course of the voltage across the coupling circuit (140).

2. The apparatus according to claim 1, wherein the control circuit (130) is further configured to set an impedance value of the adjustable impedance (150) depending on an operating voltage and/or an operating current of the electronic system (190).

3. The apparatus according to claim 1 or claim 2, wherein the switch (160) is a transistor (260), and wherein the apparatus further comprises a driver (265) which is configured to control the conductivity of the transistor (260) based on the test signal (131).

4. A DC-DC converter (500), comprising:
a voltage converter circuit (510) configured to convert an input voltage with a first voltage level into an output voltage with a different second voltage level; and
an apparatus (520) for frequency characterization of an electronic system according to any of claims 1 to 3, wherein the two terminals of the apparatus are coupled to input terminals of the DC-DC converter which receive the input voltage or to output terminals of the DC-DC converter which output the output voltage.

5. The DC-DC converter according to claim 4, wherein the apparatus (520) for frequency characterization is further configured to output an impedance signal representing an impedance at the input terminals or the output terminals of the DC-DC converter, and wherein the voltage converter circuit (510) is configured to:
set a control parameter based on the impedance signal; and/or
execute a safety routine based on the impedance signal.

6. A method (600) for frequency characterization of an electronic system, comprising:
coupling (602) a test signal into the electronic system;
measuring (604) a current at the electronic system to generate at least one measurement result;
cross-correlating (606) the at least one measurement result with the test signal to generate a first correlation result;
Fourier-transforming (608) the first correlation result to generate a first course signal representing a frequency course of the current;
measuring a voltage at the electronic system to generate at least one second measurement result;
cross-correlating the at least one second measurement result with the test signal to generate a second correlation result; and
Fourier-transforming the second correlation result to generate a second course signal representing a frequency course of the voltage,
wherein the aforementioned method steps are performed by an apparatus for frequency characterization according to any one of claims 1 to 3.

## Revendications

1. Appareil (100) de caractérisation fréquentielle d'un système électronique (190), comprenant :
deux bornes (110, 120) configurées pour coupler avec le système électronique (190) ;
un circuit de commande (130) configuré pour générer un signal de test (131), le signal de test (131) étant un signal rectangulaire, et une longueur d'une fenêtre rectangulaire du signal rectangulaire étant ajustée en fonction d'une gamme de fréquence mesurable souhaitée ;
un circuit de couplage (140) comprenant une impédance ajustable (150) et un interrupteur (160) couplés en série, des nœuds d'extrémité (141, 142) du circuit de couplage (140) étant couplés aux deux bornes (110, 120), et l'interrupteur (160) étant configuré pour coupler électriquement les deux bornes (110, 120) l'une à l'autre sur la base du signal de test (130) ; et
un circuit de mesure (270, 280) configuré pour générer un premier signal de mesure représentant le courant à travers le circuit de couplage (140) et un deuxième signal de mesure représentant la tension à travers le circuit de couplage (140), le circuit de mesure (270, 280) étant en outre configuré pour générer le premier signal de mesure et le deuxième signal de mesure de manière synchrone avec le signal de test (131),
le circuit de commande (130) étant en outre configuré pour :
générer, sur la base d'une première intercorrélation du premier signal de mesure et du signal de test (131) ainsi que d'une transformation de Fourier suivante du résultat de la première intercorrélation, un premier signal représentant une allure de fréquence du courant à travers le circuit de couplage (140) ; et
générer, sur la base d'une deuxième intercorrélation du deuxième signal de mesure et du signal de test (130) ainsi que d'une transformation de Fourier suivante du résultat de la deuxième intercorrélation, un deuxième signal représentant une allure de fréquence de la tension à travers le circuit de couplage (140).

2. Appareil selon la revendication 1, le circuit de commande (130) étant en outre configuré pour régler une valeur d'impédance de l'impédance ajustable (150) en fonction d'une tension de travail et/ou d'un courant de travail du système électronique (190).

3. Appareil selon la revendication 1 ou la revendication 2, l'interrupteur (160) étant un transistor (260), et l'appareil comprenant en outre un pilote (265) configuré pour contrôler la conductivité du transistor (260) sur la base du signal de test (131).

4. Convertisseur continu/continu (500) comprenant :
un circuit de conversion de tension (510) configuré pour convertir une tension d'entrée ayant un premier niveau de tension en une tension de sortie ayant un deuxième niveau de tension différent ; et
un appareil (520) de caractérisation fréquentielle d'un système électronique selon l'une des revendications 1 à 3, les deux bornes de l'appareil étant couplées à des bornes d'entrée du convertisseur continu/continu recevant la tension d'entrée ou à des bornes de sortie du convertisseur continu/continu délivrant la tension de sortie.

5. Convertisseur continu/continu selon la revendication 4, l'appareil (520) de caractérisation fréquentielle étant en outre configuré pour délivrer un signal d'impédance représentant une impédance aux bornes d'entrée ou aux bornes de sortie du convertisseur continu/continu, et le circuit de conversion de tension (510) étant configuré pour :
ajuster un paramètre de contrôle sur la base du signal d'impédance ; et/ou
effectuer une routine de sécurité sur la base du signal d'impédance.

6. Procédé (600) de caractérisation fréquentielle d'un système électronique, comprenant le fait de :
coupler (602) un signal de test dans le système électronique ;
mesurer (604) un courant sur le système électronique afin de générer au moins un résultat de mesure ;
intercorréler (606) l'au moins un résultat de mesure avec le signal de test afin de générer un premier résultat de corrélation ;
effectuer une transformation de Fourier (608) du premier résultat de corrélation afin de générer un premier signal d'allure représentant une allure de fréquence du courant ;
mesurer une tension sur le système électronique afin de générer au moins un deuxième résultat de mesure ;
intercorréler l'au moins un deuxième résultat de mesure avec le signal de test afin de générer un deuxième résultat de corrélation ; et
effectuer une transformation de Fourier du deuxième résultat de corrélation afin de générer un deuxième signal d'allure représentant une allure de fréquence de la tension,
les étapes de procédé susmentionnées étant réalisées par un appareil de caractérisation fréquentielle selon l'une des revendications 1 à 3.
